# EUROPÄISCHE PATENTSCHRIFT

(11) **EP 3 631 483 B1**
(45) Veröffentlichungstag und Bekanntmachung des Hinweises auf die Patenterteilung: **28.07.2021**
(21) Anmeldenummer: 18739739.3
(22) Anmeldetag: 25.06.2018
(51) Int. Cl.: G01R 31/08, H02H 3/00, H02H 3/087, H02H 3/38, H02H 7/26, G05B 23/02

(54) **VERFAHREN UND EINRICHTUNG ZUR FEHLERORTUNG ENTLANG EINER ENERGIEVERSORGUNGSSTRECKE BEI GLEICHSTROMSYSTEMEN**
METHOD AND DEVICE FOR LOCATING FAULTS ALONG AN ENERGY SUPPLY CHAIN FOR DC CURRENT SYSTEMS
PROCÉDÉ ET DISPOSITIF DE LOCALISATION DE DÉFAUTS SUR UNE LIGNE D'ALIMENTATION EN ÉNERGIE POUR DES SYSTÈMES À COURANT CONTINU

(30) Priorität: 25.07.2017 DE 102017212730
(43) Veröffentlichungstag der Anmeldung: 08.04.2020
(73) Patentinhaber: Siemens Mobility GmbH, 81739 München (DE)
(72) Erfinder: BRAUN, Wolfgang, 96191 Viereth-Trunstadt (DE); SCHMIDT, Martin, 91052 Erlangen (DE); NÖLKENSMEIER, Stephan, 91052 Erlangen (DE)
(86) Internationale Anmeldenummer: PCT/EP2018/066851
(87) Internationale Veröffentlichungsnummer: WO 2019/020296

(56) Entgegenhaltungen:
- EP-A1- 2 998 750
- EP-A1- 3 193 420

## Beschreibung

Bei Bahnstromversorgungssystemen können im Betrieb Kurzschlüsse entlang der Energieversorgungsstrecke entstehen. Dabei ist es egal, ob ein Oberleitungssystem, ein Dritte-Schiene-System oder ein anderes System verwendet wird. Diese Betriebs-Kurzschlüsse können beispielsweise durch defekte Fahrzeuge oder Züge, von defekten Fahrleitungsteilen, durch Unfälle mit Straßenfahrzeugen, Kränen oder durch umgestürzte Bäume entstehen. Speiseabschnitte der Energieversorgungsstrecke, in denen die Kurzschlüsse auftreten, sind im Nahverkehr in der Regel bis zu 2 km und im Fernverkehr bis zu 20 km lang. Entsteht ein Betriebs-Kurzschluss, weiß der Bahnbetreiber zwar in welchem Speiseabschnitt der Energieversorgungsstrecke sich der Kurzschluss befindet. Aber es fehlt eine Information darüber, wo genau sich der Fehlerort des Betriebs-Kurzschlusses befindet. Betriebs-Kurzschluss sei im Folgenden ein im Betrieb auftretender Kurzschluss.

Bei Gleichstrombahnsystemen hat der Betreiber der Energieversorgungsstrecke üblicherweise keine Möglichkeit, den Fehlerort eines Betriebs-Kurzschlusses zu detektieren. Er ist auf Informationen von Dritten zu dem Fehlerort angewiesen. Im Fall eines defekten Zugs oder eines Unfalls, können diese beispielsweise durch die Fahrzeugführer gemeldet werden. Aber beispielsweise bei einem Fehler durch beschädigte Fahrleitungskomponenten oder Isolationsfehler muss der komplette Speiseabschnitt abgefahren werden, um den Fehlerort zu finden.

Bei Wechselspannungssystemen sind Verfahren bekannt, die eingesetzt werden, um den Fehlerort automatisch zu bestimmen. Bei Gleichstrombahnsystemen sind solche Verfahren bisher nicht im Einsatz.

In der RU 22 37 905 C2 ist zwar ein Verfahren zur Fehlerortung beschrieben, das auch für Gleichstrom anwendbar ist. Allerdings findet dieses Verfahren bisher keine Anwendung.

Weitere einschlägige Verfahren und Einrichtungen sind den Dokumenten EP 2 998 750 A1 und EP 3 193 420 A1 entnehmbar.

Auch bei anderen Gleichstromsystemen, wie beispielsweise HGÜ (Hochspannungsgleichstromübertragung) oder einer Stromversorgung für Rechenzentren, können Betriebs-Kurzschlüsse auftreten, deren schnelle Ortung vorteilhaft ist. Die Erfindung kann daher für verschiedenartige Gleichstromsysteme eingesetzt werden.

Der Erfindung liegt daher die Aufgabe zugrunde, ein Verfahren und eine Einrichtung zur Fehlerortung entlang einer Energieversorgungsstrecke bei Gleichstromsystemen bereitzustellen, mit denen der Fehlerort zuverlässig und auf einfache Weise bestimmt werden kann.

Erfindungsgemäß wird die Aufgabe gelöst durch ein Verfahren zur Fehlerortung entlang einer Energieversorgungsstrecke bei Gleichstromsystemen, bei denen wenigstens ein Referenz-Kurzschluss an einem bekannten Referenz-Fehlerort der Energieversorgungsstrecke erzeugt und zumindest eine physikalische Eigenschaft der Energieversorgungsstrecke während des Referenz-Kurzschlusses ermittelt wird, bei dem wenigstens eine physikalische Eigenschaft der Energieversorgungsstrecke beim Betriebs-Kurzschluss ermittelt wird und bei dem ein Fehlerort des Betriebs-Kurzschlusses wenigstens unter Berücksichtigung der ermittelten physikalischen Eigenschaften während des Referenz-Kurzschlusses und des Betriebs-Kurzschlusses sowie des Referenz-Fehlerorts ermittelt wird. Ferner löst die Erfindung die Aufgabe, durch eine Einrichtung der Fehlerortung entlang einer Energieversorgungsstrecke bei Gleichstromsystemen, mit einer Messeinrichtung, die zum Ermitteln wenigstens einer physikalischen Eigenschaft der Energieversorgungsstrecke während eines Referenz-Kurzschlusses und eines Betriebs-Kurzschlusses ausgebildet ist, und mit einer Recheneinrichtung, die zum Ermitteln eines Fehlerorts des Betriebs-Kurzschlusses wenigstens unter Berücksichtigung der ermittelten physikalischen Eigenschaften während des Referenz-Kurzschlusses und des Betriebskurzschlusses sowie eines Referenz-Fehlerorts ausgebildet ist.

Durch die erfindungsgemäße Lösung kann der Fehlerort des Betriebs-Kurzschlusses auf einfache Weise zuverlässig ermittelt werden. Hierfür wird zunächst eine Referenzmessung durchgeführt, bei dem der Referenz-Kurzschluss an einem bekannten Referenz-Fehlerort erzeugt wird. Der Referenz-Kurzschluss unterscheidet sich vom Betriebs-Kurzschluss dadurch, dass er beabsichtigt während der Referenzmessung erzeugt wird. Während des Referenz-Kurzschlusses wird durch die Messeinrichtung wenigstens eine physikalische Eigenschaft der Energieversorgungsstrecke, beispielsweise ein zeitlicher Verlauf der Stromstärke und/oder der Spannung - also der Fehlerstrom und/oder die Fehlerspannung -, ermittelt. Diese wenigstens eine physikalische Eigenschaft sowie Position des bekannten Referenz-Fehlerorts werden abgespeichert. Wenn im Betrieb des Gleichstromsystems nun ein Betriebs-Kurzschluss auftritt, wird erfindungsgemäß wenigstens eine physikalische Eigenschaft der Energieversorgungsstrecke bei diesem Betriebs-Kurzschluss, beispielsweise der Fehlerstrom und/oder die Fehlerspannung, ermittelt. Anschließend kann von der Recheneinrichtung der Fehlerort des Betriebs-Kurzschlusses bestimmt werden. Dabei werden zumindest die wenigstens eine ermittelte physikalische Eigenschaft während des Referenz-Kurzschlusses und die wenigstens eine ermittelte physikalische Eigenschaft während des Betriebs-Kurzschlusses sowie der Referenz-Fehlerort berücksichtigt.

Erfindungsgemäß muss also lediglich diese Referenzmessung mit dem Referenz-Kurzschluss durchgeführt werden, um anschließend im Betrieb des Gleichstromsystems einen Fehlerort eines auftretenden Betriebs-Kurzschlusses ermitteln zu können.

Durch den automatisch ermittelten Fehlerort können sehr schnell gezielte Maßnahmen eingeleitet werden, um den Betrieb des Gleichstromsystems schnell wieder aufzunehmen. Eine solche Maßnahme kann beispielsweise der gezielte Einsatz eines Wartungsteams am Fehlerort des Betriebs-Kurzschlusses sein. Alternativ könnte beispielsweise zunächst auch eine Drohne mit Kamerasystem an den Fehlerort geschickt werden, um ein erstes Bild des Fehlerorts zu liefern. Dadurch kann beispielsweise ein auf die Oberleitung umgestürzter Baum sofort erkannt und geeignete Gegenmaßnahmen können eingeleitet werden.

Die Erfindung ist im Folgenden häufig mit Bezug zu einem Gleichstrombahnsystem beschrieben. Dies ist aber nur als ein Beispiel zu verstehen. Eine Anwendung bei anderen Gleichstromsystemen ist ebenfalls vorteilhaft und möglich.

Die erfindungsgemäße Lösung kann durch vorteilhafte Ausgestaltungen weiter entwickelt werden, die im Folgenden beschrieben sind.

So kann wenigstens ein von der Länge der Energieversorgungsstrecke abhängiger Rechenwert wenigstens mittels der ermittelten physikalischen Eigenschaft während des Referenz-Kurzschlusses und mittels des Referenz-Fehlerorts ermittelt und der Fehlerort des Betriebs-Kurzschlusses unter Berücksichtigung dieses Rechenwertes und der ermittelten physikalischen Eigenschaften während des Betriebs-Kurzschlusses ermittelt werden. Dies hat den Vorteil, dass die Berechnung des Fehlerorts vereinfacht wird. Als Rechenwert kann in einer besonders vorteilhaften Ausführungsform beispielsweise eine Induktivität pro Länge der Energieversorgungsstrecke ermittelt werden. Die Induktivität ist hier als Rechenwert besonders geeignet, weil sie die Änderungsrate des Stroms mit der Spannung in Beziehung setzt. Da z. B. die Änderungsrate des Fehlerstroms leicht ermittelt werden kann, ist die Erfindung einfach anwendbar.

Um die Genauigkeit bei der Bestimmung des Fehlerorts weiter zu erhöhen, kann ein Widerstand pro Länge der Energieversorgungsstrecke ermittelt und bei der Bestimmung des Fehlerorts mit berücksichtigt werden. Der Widerstand, beispielsweise ein Kabelwiderstand, der Energieversorgungsstrecke kann negativen Einfluss auf die Genauigkeit bei der Berechnung des Fehlerorts haben und ist daher vorzugsweise herauszurechnen.

Um die nötigen Messungen zu vereinfachen, kann beim Referenz-Kurzschluss und beim Betriebs-Kurzschluss die gleiche physikalische Eigenschaft der Energieversorgungsstrecke ermittelt werden. Ferner kann als physikalische Eigenschaft der Energieversorgungsstrecke beim Referenz-Kurzschluss und beim Betriebs-Kurzschluss jeweils der zeitliche Verlauf des Fehlerstroms und/oder der Fehlerspannung ermittelt werden. Die Ermittlung des Fehlerstroms und der Fehlerspannung ist einfach durchführbar und kann daher ohne großen Aufwand genutzt werden. Zusätzlich können weitere physikalische Eigenschaften beim Referenz-Kurzschluss und beim Betriebs-Kurzschluss ermittelt werden.

Um mögliche Schäden des Gleichstromsystems zu vermeiden, kann der Betriebs-Kurzschluss erkannt und anschließend die Energieversorgung der Energieversorgungsstrecke abgeschaltet werden und die wenigstens eine physikalische Eigenschaft der Energieversorgungsstrecke beim Betriebs-Kurzschluss bis zum Abschalten ermittelt werden. Durch die erfindungsgemäße Lösung kann der Fehlerort ermittelt werden, auch wenn beim Betriebs-Kurzschluss die Energieversorgungsstrecke durch die Abschaltung nur kurzzeitig mit Energie versorgt wird. Insbesondere kann der weitere prospektive Verlauf der wenigstens einen physikalischen Eigenschaft extrapoliert werden. Als prospektiver Verlauf ist hier der Verlauf zu verstehen, der sich ohne die Abschaltung einstellen würde. Dies hat den Vorteil, dass durch die Extrapolation ein längerer Verlauf der Eigenschaft zur Verfügung steht, der die Genauigkeit der Fehlerortung erheblich erhöht. Die Extrapolation kann beispielsweise durch Glättung und/oder lineare Regression mit der Methode der kleinsten Fehlerquadrate geschehen. Die Extrapolation kann auch beim Referenz-Kurzschluss angewendet werden, um einen längeren Verlauf der wenigstens einen physikalischen Eigenschaft beim Referenz-Kurzschluss zu erhalten.

Die Energieversorgung kann beim erkannten Betriebs-Kurzschluss innerhalb von weniger als 500 ms, insbesondere weniger als 200 ms, abgeschaltet werden.

Um die Genauigkeit bei der Bestimmung des Fehlerorts weiter zu erhöhen, kann im Vergleich zum Betriebs-Kurzschluss beim Referenz-Kurzschluss die Energieversorgung nicht oder später abgeschaltet werden. So erreicht der Fehlerstrom beispielsweise ein Maximum, wodurch die Referenzmessung informativer ist.

In einer vorteilhaften Ausgestaltung der erfindungsgemäßen Einrichtung zur Fehlerortung kann diese wenigstens eine Kommunikationseinrichtung aufweisen, die zum Übermitteln des Fehlerorts des Betriebs-Kurzschlusses, insbesondere an eine Leitstelle des Gleichstromsystems, ausgebildet ist. Dies hat den Vorteil, dass der ermittelte Fehlerort schnell an die Stelle weitergeleitet werden kann, die diese Information benötigt. Bei einer Bahnanlage kann dies beispielsweise die Leitstelle oder ein Leitstand sein. Die Übermittlung des Fehlerorts kann hierbei kabelgebunden, beispielsweise beim Vorhandensein eines Netzwerks, wie Ethernet, oder kabellos erfolgen, wie beispielsweise über WLAN oder GSM-R.

Weiterhin kann die Einrichtung zur Fehlerortung zur Durchführung des erfindungsgemäßen Verfahrens nach einer der oben beschriebenen Ausführungsformen ausgebildet sein.

Schließlich betrifft die Erfindung auch ein Schutz- und Steuergerät für Gleichstrombahnsysteme, mit einer Detektionseinrichtung, die zum Erkennen eines Betriebs-Kurzschlusses an einer Energieversorgungsstrecke des Gleichstromsystems ausgebildet ist, Um den Fehlerort eines Betriebs-Kurzschlusses zuverlässig zu erkennen, ist es erfindungsgemäß vorgesehen, dass das Schutz- und Steuergerät wenigstens eine Einrichtung zur Fehlerortung nach einer der zuvor genannten Ausführungsformen aufweist.

Im Folgenden wird die Erfindung mit Bezug auf die beigefügten Zeichnungen und die darin dargestellten beispielhaften Ausführungsformen der Erfindung beschrieben.

Es zeigen:
- Figur 1: eine schematische Darstellung eines Gleichstrombahnsystems mit erfindungsgemäßen Schutz- und Steuergeräten;
- Figur 2: eine schematische Darstellung eines prospektiven Stromverlaufs bei Kurzschlüssen an unterschiedlichen Fehlerorten in dem Bahnsystem nach Figur 1;
- Figur 3: eine schematische Darstellung eines Stromverlaufs bei einem Betriebs-Kurzschluss, bei dem die Stromversorgung abgeschaltet wird;
- Figur 4: eine schematische Darstellung einer erfindungsgemäßen Einrichtung zur Fehlerortung aus Figur 1.

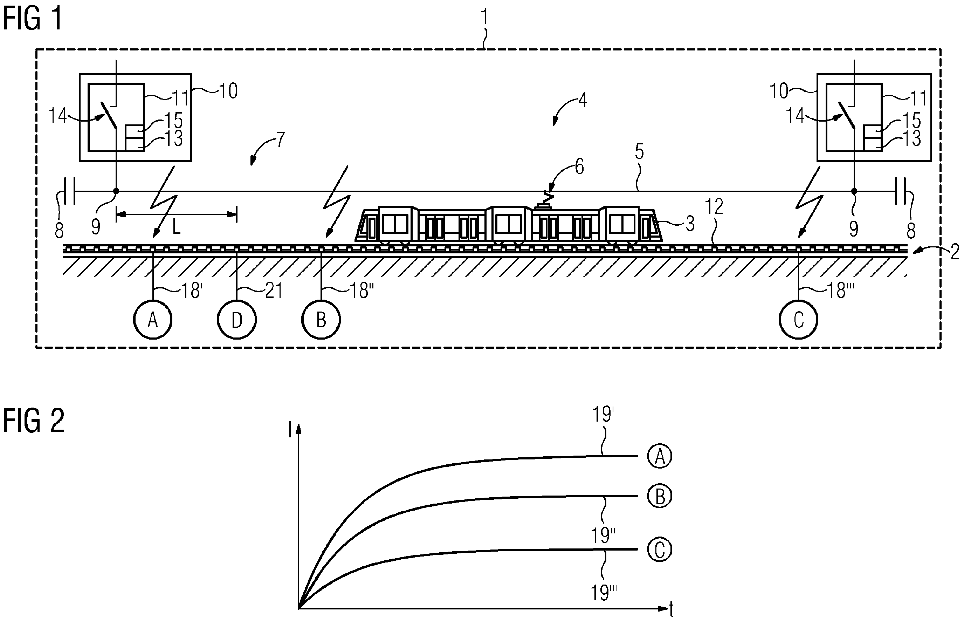

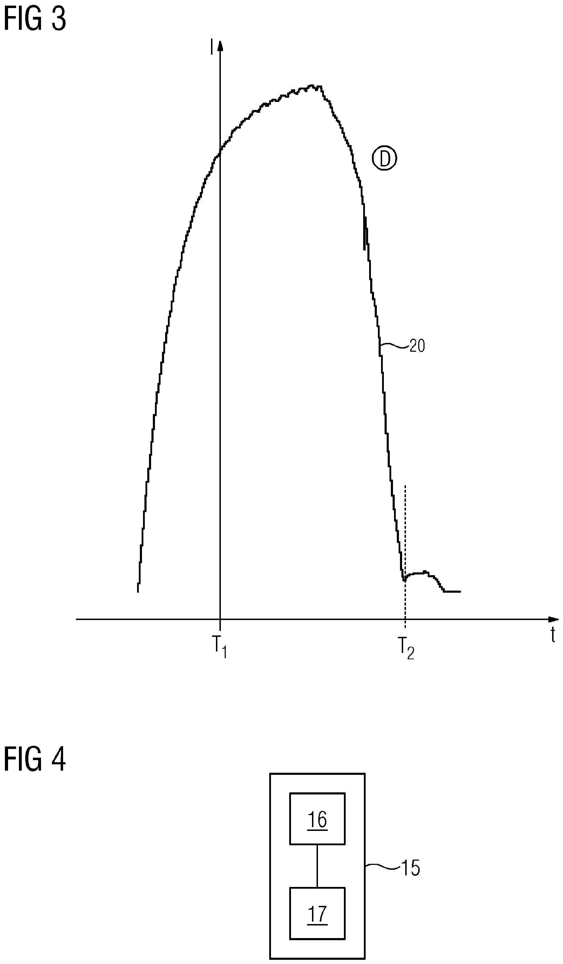

Im Folgenden wird die Erfindung mit Bezug auf die in Figur 1 dargestellte beispielhafte Ausführungsform eines erfindungsgemäßen Schutz- und Steuergerätes und den Diagrammen in Figuren 2 und 3 beschrieben.

Figur 1 zeigt ein Gleichstrombahnsystem 1, das beispielhaft als ein Straßenbahnsystem dargestellt ist. Das Gleichstrombahnsystem 1 weist eine Fahrstrecke 2 auf, auf der sich Fahrzeuge 3 bewegen. Das einzige in Figur 1 dargestellte Fahrzeug 3 ist beispielhaft als eine Straßenbahn ausgebildet. Ferner umfasst das Gleichstrombahnsystem 1 eine Energieversorgungsstrecke 4, die das Fahrzeug 3 mit elektrischer Energie versorgt. Die Energieversorgungsstrecke 4 weist in der Ausführungsform in Figur 1 eine Oberleitung 5 auf, die von dem Fahrzeug 3 mittels eines Stromabnehmers 6 kontaktiert wird. Die Energieversorgungsstrecke 4 umfasst üblicherweise mehrere Speiseabschnitte 7, von denen in Figur 1 lediglich einer dargestellt ist.

Die Speiseabschnitte 7 sind entlang der Fahrstrecke 2 hintereinander angeordnet und durch Trennstellen 8 voneinander getrennt. Jeder Speiseabschnitt 7 wird an wenigstens einer Verbindungsstelle 9 von einer Energieversorgung 10, beispielsweise einem Unterwerk, mit elektrischer Energie gespeist. Bei der Ausführungsform in Figur 1 wird der einzige dargestellte Speiseabschnitt 7 von zwei Seiten an zwei Verbindungsstellen 9 mit Energie versorgt. Die Energieversorgung 10 umfasst mindestens ein Schaltfeld 11, welches die Verbindungsstelle 9 mit Energie versorgt. In dem Schaltfeld 11 ist jeweils ein erfindungsgemäßes Schutz- und Steuergerät angeordnet, das im Folgenden noch genauer beschrieben wird. Da es sich bei dem Bahnsystem in Figur 1 um ein mit einer Gleichspannung betriebenes Gleichstrombahnsystem 1 handelt, stellt die Oberleitung 5 den einen Pol und eine Fahrschiene 12 entlang der Fahrstrecke 2 den anderen Pol dar. Andere bekannte Systeme zur Versorgung von Gleichstrombahnen sind selbstverständlich auch möglich, wie beispielsweise ein Dritte-Schienen-System oder andere Systeme.

Die Schaltfelder 11 weisen jeweils eine Detektionseinrichtung 13, eine Abschalteinrichtung 14 und eine Einrichtung zur Fehlerortung 15 auf. Weiterhin ist auch die Schutz- und Steuereinrichtung ebenfalls Teil des jeweiligen Schaltfeldes 11. Die Schutz- und Steuereinrichtung umfasst die Detektionseinrichtung 13 und die Einrichtung zur Fehlerortung 15.

Die Detektionseinrichtung 13 ist zum Erkennen von Betrieb-Kurzschlüssen an der Energieversorgungsstrecke 4 ausgebildet.

Die Abschalteinrichtung 14 ist mit der Detektionseinrichtung 13 verbunden und kann die Verbindung zur Energieversorgung 10 bei einem von der Detektionseinrichtung 13 erkannten Betriebs-Kurzschluss unterbrechen. Die Abschalteinrichtung 14 ist beispielsweise als ein Trennschalter, Lasttrennschalter oder Leistungsschalter ausgebildet.

Die erfindungsgemäße Einrichtung zur Fehlerortung 15 ist ausgebildet, im Betrieb des Gleichstrombahnsystems 1 den Fehlerort 21 eines Betriebs-Kurzschlusses D zu bestimmen.

Die Einrichtung zur Fehlerortung 15 umfasst wiederum eine Messeinrichtung 16 und eine Recheneinrichtung 17. Eine beispielhafte Ausführungsform der Einrichtung der Fehlerortung 15 ist schematisch in Figur 4 dargestellt. Als Messeinrichtung 16 für die Einrichtung zur Fehlerortung kann auch eine andere verfügbare Einrichtung verwendet werden, die die nötigen Messwerte ermittelt, wie beispielsweise eine Messeinrichtung (nicht dargestellt) der Detektionseinrichtung 13. Ebenso kann die Recheneinrichtung 17 der Einrichtung zur Fehlerortung 15 auch in eine andere Recheneinrichtung integriert sein, wie beispielsweise eine Recheneinrichtung (nicht dargestellt) der Detektionseinrichtung 13. Selbstverständlich kann die Einrichtung zur Fehlerortung 15 auch an anderer Stelle der Energieversorgung 10 angeordnet sein.

Die Messeinrichtung 16 ist zum Ermitteln von physikalischen Eigenschaften der Energieversorgungsstrecke 4 und insbesondere des Speiseabschnitts 7 ausgebildet.

Die Recheneinrichtung 17 ist mit der Messeinrichtung 16 signaltechnisch verbunden und zum Ermitteln des Fehlerortes von Betriebs-Kurzschlüssen ausgebildet.

Im Folgenden wird beschrieben, wie die Einrichtung 15 zur Fehlerortung den Fehlerort 21 eines Betriebs-Kurzschlusses D mit Hilfe des erfindungsgemäßen Verfahrens zur Fehlerortung ermittelt.

Zunächst wird beispielsweise vor der Inbetriebnahme des Gleichstrombahnsystems 1 eine Referenzmessung durchgeführt. Bei der Referenzmessung wird quasi künstlich wenigstens ein Referenz-Kurzschluss A, B, C an einem bekannten Referenz-Fehlerort 18 erzeugt. Hierfür wird beispielsweise ein Kabel am Referenz-Fehlerort 18', 18", 18"' zwischen der Oberleitung 5 und der Fahrschiene 12 installiert. Anschließend werden physikalische Eigenschaften der Energieversorgungsstrecke 4 während des Referenz-Kurzschlusses ermittelt. Solche physikalischen Eigenschaften sind beispielsweise der Verlauf des Stroms I, der auch als Fehlerstrom bezeichnet werden kann, und der Verlauf der Spannung U (nicht dargestellt), die auch als Fehlerspannung bezeichnet werden kann, jeweils über die Zeit t. Der Stromverlauf während des Referenz-Kurzschlusses ist in Figur 2 mit jeweils einer Kurve 19', 19", 19"' für die unterschiedlichen Referenz-Kurzschlüsse A, B ,C dargestellt. Um möglichst viele Messwerte und etwa den maximalen Fehlerstrom zu erreichen, wird bei dem Referenz-Kurzschluss die Energieversorgung 10 relativ lange im Vergleich zu einem Betriebs-Kurzschluss aufrecht erhalten. Es kann allerdings auch sein, dass die in Figur 2 dargestellten Verläufe nicht erreicht werden, weil die Energieversorgung bei der Referenzmessung bedingt durch den Referenz-Kurzschluss abgeschaltet wird. In diesem Fall kann der prospektive Verlauf extrapoliert werden, um den Verlauf gemäß Figur 2 bzw. dessen Werte zu erhalten. Die Extrapolation wird im Folgenden mit Bezug auf den Betriebs-Kurzschluss noch genauer beschrieben.

Aus den ermittelten physikalischen Eigenschaften, inklusive dem gegebenenfalls extrapolierten Verlauf, wird bei der beispielhaften Ausführungsform in den Figuren anschließend als ein Rechenwert eine Induktivität der Energieversorgungsstrecke 4 pro Länge der Energieversorgungsstrecke ermittelt. Die se wird beispielsweise in der Einheit H/m bzw. mH/km angegeben.

Um die Genauigkeit des erfindungsgemäßen Verfahrens zu erhöhen, werden vor der Inbetriebnahme des Gleichstrombahnsystems 1 der Widerstand und die Induktivität der Energieversorgungsstrecke 4 ermittelt und ein normierter Wert des Widerstands und der Induktivität jeweils pro Länge der Energieversorgungsstrecke 4 ermittelt. Der Widerstand und die Induktivität pro Länge werden bei der Ermittlung des Rechenwerts bei dieser Ausführungsform mit berücksichtigt.

Der ermittelte Rechenwert bzw. die Rechenwerte werden in der erfindungsgemäßen Recheneinrichtung abgespeichert. Anschließend kann das Gleichstrombahnsystem 1 in Betrieb genommen werden.

Wenn nun ein Betriebskurzschluss D auftritt, wird dieser durch die Detektionseinrichtung 13 erkannt. Die Abschalteinrichtung 14 trennt anschließend, beispielsweise innerhalb von weniger als 500 ms, insbesondere weniger als 200 ms, die Energieversorgung 10 zum Schutz von der Energieversorgungsstrecke 4. Bis zur Trennung ermittelt die Messeinrichtung 16 die physikalischen Eigenschaften der Energieversorgungsstrecke 4, wie beispielsweise den in Figur 3 schematisch dargestellten Stromverlauf 29 und einen nicht dargestellten Spannungsverlauf.

Wie in Figur 3 ersichtlich, hat die Abschalteinrichtung 14 in einem Zeitpunkt T2 die Energieversorgung 10 unterbrochen. Vom Eintrittszeitpunkt des Kurzschlusses bis zum Zeitpunkt T1 ist der Strom I bedingt durch die Induktivität der Energieversorgungsstrecke 4 angestiegen. Zwischen T1 und T2 ist der Strom I durch den Ausschaltvorgang beeinflusst. Aus dem Verlauf des Anstiegs des Fehlerstroms I vor T1 und gegebenenfalls aus dem Verlauf der Fehlerspannung U wird erfindungsgemäß der Fehlerort 21 des Betriebs-Kurzschlusses D ermittelt. Hierzu wird die Kurve 20 des Stromverlaufs des Betriebs-Kurzschlusses D mit dem Stromverlauf des Referenz-Kurzschlusses A, B, C verglichen und daraus der Fehlerort 21 bestimmt. Bei der Bestimmung des Fehlerorts 21 wird bei dieser Ausführungsform zusätzlich auch der Spannungsverlauf des Betriebs-Kurzschlusses D mit dem Spannungsverlauf des Referenz-Kurzschlusses verglichen. Um dies automatisiert durchführen zu können, wird aus dem ermittelten Fehlerstrom- und Fehlerspannungsverläufen beim Betriebs-Kurzschluss D bis zum Zeitpunkt T1 die Induktivität ermittelt. Der Zeitpunkt T1 ist der Zeitpunkt, bei dem ein Abschaltbefehl erteilt wird. Ab diesem Zeitpunkt wird der Stromverlauf durch die Abschalteinrichtung 14 beeinflusst und ist daher verfälscht. Ab dem Zeitpunkt T1 wird der Stromverlauf zur Ermittlung der Induktivität nicht mehr verwendet.

Aus den unbeeinflussten Verläufen des Stromes und der Spannung wird der weitere prospektive Strom- und Spannungsverlauf extrapoliert. Dies kann beispielsweise mittels Glättung und/oder linearer Regression mit der Methode der kleinsten Fehlerquadrate geschehen. Diese ist beispielsweise in "A Prototype of Multiprocessor Based Distance Relay", IEEE Transactions on Power Apparatus and Systems (Volume: PAS-101, Issue: 2, Feb. 1982) beschrieben. Aus den extrapolierten Verläufen kann auf die Induktivität und den Widerstand der Fehlerschleife, also des Betriebs-Kurzschlusses, geschlossen werden.

Da in der Recheneinrichtung 17 der Rechenwert der Induktivität und des Widerstandes pro Länge der Energieversorgungsstrecke 4 bekannt sind, kann somit anhand der ermittelten Induktivität des Betriebs-Kurzschlusses D die Länge l des Fehlerorts 21, also den Abstand des Fehlerorts 21 zur Verbindungsstelle 9, ermittelt werden.

## Patentansprüche

1. Verfahren zur Fehlerortung entlang einer Energieversorgungsstrecke (4) bei Gleichstromsystemen (1),
bei dem wenigstens ein Referenz-Kurzschluss (A, B, C) an einem bekannten Referenz-Fehlerort (18', 18", 18"') der Energieversorgungsstrecke (4) erzeugt und zumindest eine physikalische Eigenschaft der Energieversorgungsstrecke (4) während des Referenz-Kurzschlusses ermittelt wird,
bei dem wenigstens eine physikalische Eigenschaft der Energieversorgungsstrecke (4) bei einem Betriebs-Kurzschluss (D) ermittelt wird und
bei dem ein Fehlerort (21) des Betriebs-Kurzschlusses (D) wenigstens unter Berücksichtigung der ermittelten physikalischen Eigenschaft während des Referenz-Kurzschlusses und des Betriebs-Kurzschlusses sowie des Referenz-Fehlerortes ermittelt wird.

2. Verfahren nach Anspruch 1,
**dadurch gekennzeichnet, dass**
der Betriebs-Kurzschluss erkannt und anschließend die Energieversorgung der Energieversorgungsstrecke abgeschaltet wird und die wenigstens eine physikalische Eigenschaft der Energieversorgungsstrecke zumindest bis zur Einflussnahme des Abschaltens ermittelt wird.

3. Verfahren nach Anspruch 2,
**dadurch gekennzeichnet, dass**
der weitere prospektive Verlauf der wenigstens einen physikalischen Eigenschaft extrapoliert wird.

4. Verfahren nach Anspruch 2 oder 3,
**dadurch gekennzeichnet, dass**
die Energieversorgung beim erkannten Betriebs-Kurzschluss innerhalb von weniger als 500 ms, insbesondere weniger als 200 ms, abgeschaltet wird.

5. Verfahren nach Anspruch 2 bis 4,
**dadurch gekennzeichnet, dass**
im Vergleich zum Betriebs-Kurzschluss beim Referenz-Kurzschluss die Energieversorgung nicht oder später abgeschaltet wird.

6. Verfahren nach einem der oben genannten Ansprüche,
**dadurch gekennzeichnet, dass** wenigstens ein von der Länge der Energieversorgungsstrecke(4) abhängiger Rechenwert wenigstens mittels der ermittelten physikalischen Eigenschaft während des Referenz-Kurzschlusses und mittels des Referenz-Fehlerorts ermittelt und
der Fehlerort des Betriebs-Kurzschlusses unter Berücksichtigung dieses Rechenwertes und der ermittelten physikalischen Eigenschaften während des Betriebs-Kurzschlusses ermittelt wird.

7. Verfahren nach Anspruch 6,
**dadurch gekennzeichnet, dass**
als Rechenwert eine Induktivität pro Länge der Energieversorgungsstrecke ermittelt wird.

8. Verfahren nach Anspruch 6 oder 7,
**dadurch gekennzeichnet, dass**
als Rechenwert ein Widerstand pro Länge der Energieversorgungsstrecke (4) ermittelt wird.

9. Verfahren nach einem der oben genannten Ansprüche,
**dadurch gekennzeichnet, dass**
beim Referenz-Kurzschluss und beim Betriebs-Kurzschluss die gleiche physikalische Eigenschaft oder die gleichen physikalischen Eigenschaften der Energieversorgungsstrecke ermittelt werden.

10. Verfahren nach einem der oben genannten Ansprüche,
**dadurch gekennzeichnet, dass**
als physikalische Eigenschaft der Energieversorgungsstrecke beim Referenz-Kurzschluss und beim Betriebs-Kurzschluss jeweils der zeitliche Verlauf eines Fehlerstroms und/oder einer Fehlerspannung ermittelt werden.

11. Einrichtung (15) zur Fehlerortung entlang einer Energieversorgungsstrecke (4) bei Gleichstromsystemen (1),
mit einer Messeinrichtung (16), die zum Ermitteln wenigstens einer physikalischen Eigenschaft der Energieversorgungsstrecke (4) während eines Referenz-Kurzschlusses an einem bekannten Referenz-Fehlerort und eines Betriebs-Kurzschlusses ausgebildet ist, und
mit einer Recheneinrichtung (17), die zum Ermitteln eines Fehlerorts des Betriebs-Kurzschlusses wenigstens unter Berücksichtigung der ermittelten physikalischen Eigenschaften während des Referenz-Kurzschlusses und des Betriebs-Kurzschlusses sowie des Referenz-Fehlerortes ausgebildet ist.

12. Einrichtung nach Anspruch 11,
**dadurch gekennzeichnet, dass**
die Einrichtung wenigstens eine Kommunikationseinrichtung aufweist, die zum Übermitteln des Fehlerorts des Betriebs-Kurzschlusses, insbesondere an eine Leitstelle des Gleichstromsystems, ausgebildet ist.

13. Einrichtung nach Anspruch 11 oder 12,
**dadurch gekennzeichnet, dass**
die Einrichtung zur Durchführung des Verfahrens nach einem der Ansprüche 1 bis 10 ausgebildet ist.

14. Schutz- und Steuergerät für Gleichstromsysteme,
mit einer Detektionseinrichtung (13), die zum Erkennen eines Betriebs-Kurzschlusses an einer Energieversorgungsstrecke des Gleichstromsystems ausgebildet ist,
**dadurch gekennzeichnet, dass**
das Schutz- und Steuergerät wenigstens eine Einrichtung nach einem der Ansprüche 11 bis 13 aufweist.

## Claims

1. Method for locating faults along an energy supply chain (4) for DC current systems (1),
in which at least one reference short circuit (A, B, C) is generated at a known reference fault location (18', 18", 18"') of the energy supply chain (4) and at least one physical property of the energy supply chain (4) is determined during the reference short circuit,
in which at least one physical property of the energy supply chain (4) is determined during an operational short circuit (D) and
in which a fault location (21) of the operational short circuit (D) is determined, taking into account at least the determined physical property during the reference short circuit and the operational short circuit and the reference fault location.

2. Method according to claim 1,
**characterised in that**
the operational short circuit is detected and then the energy supply of the energy supply chain is disconnected and the at least one physical property of the energy supply chain is determined at least until the disconnection takes effect.

3. Method according to claim 2,
**characterised in that**
the further prospective course of the at least one physical property is extrapolated.

4. Method according to claim 2 or 3,
**characterised in that**
the energy supply is switched off in the event of a detected operational short circuit within less than 500 ms, in particular less than 200 ms.

5. Method according to claim 2 to 4,
**characterised in that** in comparison with the operational short circuit, during the reference short circuit, the energy supply is not disconnected or is disconnected later.

6. Method according to one of the aforementioned claims, **characterised in that**
at least one calculation value dependent on the length of the energy supply chain (4) is determined at least by means of the determined physical property during the reference short circuit and by means of the reference fault location and
the fault location of the operational short circuit is determined, taking into account this calculation value and the determined physical properties during the operational short circuit.

7. Method according to claim 6,
**characterised in that**
one inductance per length of the energy supply chain is determined as a calculation value.

8. Method according to claim 6 or 7,
**characterised in that**
one resistance per length of the energy supply chain (4) is determined as a calculation value.

9. Method according to one of the aforementioned claims, **characterised in that**
the same physical property or the same physical properties of the energy supply chain are determined in the reference short circuit and in the operational short circuit.

10. Method according to one of the aforementioned claims, **characterised in that**
the temporal progression of a leakage current and/or an error voltage are respectively determined as a physical property of the energy supply chain during the reference short circuit and during the operational short circuit.

11. Device (15) for locating faults along an energy supply chain (4) for DC current systems (1),
with a measuring device (16) which is designed to determine at least one physical property of the energy supply chain (4) during a reference short circuit at a known reference fault location and an operational short circuit, and
with a computing device (17) which is designed to determine a fault location of the operational short circuit, taking into account at least the determined physical properties during the reference short circuit and the operational short circuit and the reference fault location.

12. Device according to claim 11,
**characterised in that**
the device has at least one communication device which is designed to transmit the fault locations of the operational short circuit, in particular to a control centre of the DC current system.

13. Device according to claim 11 or 12,
**characterised in that**
the device is designed to perform the method according to one of claims 1 to 10.

14. Protection and control device for DC current systems, with a detection device (13) which is designed to detect an operational short circuit on an energy supply chain of the DC current system,
**characterised in that**
the protection and control device has at least one device according to one of claims 11 to 13.

## Revendications

1. Procédé de localisation de défauts sur une ligne (4) d'alimentation en énergie dans des systèmes (1) à courant continu,
dans lequel on produit au moins un court-circuit (A, B, C) de référence en un emplacement (18', 18'', 18''') de défaut de référence connu de la ligne (4) d'alimentation en énergie et on détermine au moins une propriété physique de la ligne (4) d'alimentation en énergie pendant le court-circuit de référence, dans lequel on détermine au moins une propriété physique de la ligne (4) d'alimentation en énergie lors d'un court-circuit (D) de fonctionnement et
dans lequel on détermine un emplacement (21) de défaut du court-circuit (D) de fonctionnement au moins en tenant compte de la propriété physique déterminée pendant le court-circuit de référence et du court-circuit de fonctionnement, ainsi que de l'emplacement de défaut de référence.

2. Procédé suivant la revendication 1,
**caractérisé en ce que**
on détecte le court-circuit de fonctionnement et on interrompt ensuit l'alimentation en énergie de la ligne d'alimentation en énergie et on détermine la au moins une propriété physique de la ligne d'alimentation en énergie au moins jusqu'à ce que l'interruption fasse sentir son influence.

3. Procédé suivant la revendication 2,
**caractérisé en ce que**
on extrapole l'autre courbe prospective de la au moins une propriété physique.

4. Procédé suivant la revendication 2 ou 3,
**caractérisé en ce que**
on interrompt l'alimentation en énergie, lorsque le court-circuit de fonctionnement est détecté, en moins de 500 ms, notamment en moins de 200 ms.

5. Procédé suivant la revendication 2 à 4,
**caractérisé en ce que**,
en comparaison du court-circuit de fonctionnement, on n'interrompt pas ou on interrompt plus tard l'alimentation en énergie lors du court-circuit de référence.

6. Procédé suivant l'une des revendications mentionnées ci-dessus, **caractérisé en ce que**
on détermine au moins une valeur de calcul, qui dépend de la longueur de la ligne (4) d'alimentation en énergie, au moins au moyen de la propriété physique déterminée pendant le court-circuit de référence et au moyen de l'emplacement de défaut de référence et on détermine l'emplacement de défaut du court-circuit de fonctionnement en tenant compte de cette valeur de calcul et des propriétés physiques déterminées pendant le court-circuit de fonctionnement.

7. Procédé suivant la revendication 6,
**caractérisé en ce que**
on détermine comme valeur de calcul une inductance par longueur de la ligne d'alimentation en énergie.

8. Procédé suivant la revendication 6 ou 7,
**caractérisé en ce que**
on détermine comme valeur de calcul une résistance par longueur de la ligne (4) d'alimentation en énergie.

9. Procédé suivant l'une des revendications mentionnées ci-dessus, **caractérisé en ce que**
on détermine pour le court-circuit de référence et pour le court-circuit de fonctionnement la même propriété physique ou les mêmes propriétés physiques de la ligne d'alimentation en énergie.

10. Procédé suivant l'une des revendications mentionnées ci-dessus,
**caractérisé en ce que**
on détermine comme propriété physique de la ligne d'alimentation en énergie pour le court-circuit de référence et pour le court-circuit de fonctionnement respectivement la courbe en fonction du temps d'un courant de défaut et/ou d'une tension de défaut.

11. Dispositif (15) de localisation de défauts sur une ligne (4) d'alimentation en énergie dans des systèmes à courant continu, comprenant un dispositif (16) de mesure, qui est constitué pour la détermination d'au moins une propriété physique de la ligne (4) d'alimentation en énergie et pendant un court-circuit de référence en un emplacement de défaut de référence connu et pendant un court-circuit de fonctionnement, et
comprenant un dispositif (17) de calcul, qui est constitué pour la détermination d'un emplacement de défaut du court-circuit de fonctionnement au moins en tenant compte des propriétés physiques déterminées pendant le court-circuit de référence et pendant le court-circuit de fonctionnement ainsi que de l'emplacement de défaut de référence.

12. Dispositif suivant la revendication 11,
**caractérisé en ce que**
le dispositif a au moins un dispositif de communication, qui est constitué pour la transmission de l'emplacement de défaut du court-circuit de fonctionnement, notamment à un poste de conduite du système à courant continu.

13. Dispositif suivant la revendication 11 ou 12,
**caractérisé en ce que**
le dispositif est constitué pour effectuer le procédé suivant l'une des revendications 1 à 10.

14. Appareil de protection et de commande de systèmes à courant continu,
comprenant un dispositif (13) de détection, qui est constitué pour la détection d'un court-circuit de fonctionnement sur une ligne d'alimentation en énergie du système à courant continu, **caractérisé en ce que**
l'appareil de protection et de commande a au moins un dispositif suivant l'une des revendications 11 à 13.
